# EUROPEAN PATENT APPLICATION

(11) **EP 4 636 480 A2**
(43) Date of publication of application: **22.10.2025**
(21) Application number: 25170784.0
(22) Date of filing: 15.04.2025
(51) Int. Cl.: G03F 7/00, G03F 7/004, G03F 7/038, G03F 7/105

(54) **PHOTOSENSITIVE RESIN COMPOSITION, PHOTOSENSITIVE RESIN FILM, PHOTOSENSITIVE DRY FILM, PATTERNING PROCESS, DISPLAY, AND MICRO-LED DISPLAY**

(30) Priority: 19.04.2024 JP 2024067918
(71) Applicant: SHIN-ETSU CHEMICAL CO., LTD., Tokyo 1000005 (JP)
(72) Inventor: MARUYAMA, Hitoshi, Gunma (JP); KUMAZAWA, Kumiko, Gunma (JP)
(74) Representative: Schicker, Silvia

(57) **Abstract**

The present invention is a photosensitive resin composition for absorbing blue LED light that has been transmitted through a cured photoresist film containing quantum dots capable of emitting red or green fluorescence, the composition containing: (A) an acrylic resin having a (meth)acryloyl group in a side chain; (B) a dye having a maximum absorption wavelength at any wavelength of 490 to 430 nm; (C) an oxime-based photo-radical generator; (D) a surfactant; and (E) a solvent. This can provide: a photosensitive resin composition capable of easily forming a film having high lithography resolution and favorable blue light absorption property; a photosensitive resin film and a photosensitive dry film obtained by using the photosensitive resin composition; patterning processes using these; and displays obtained by using the photosensitive resin composition.

## Description

### TECHNICAL FIELD

The present invention relates to: a photosensitive resin composition; a photosensitive resin film; a photosensitive dry film; a patterning process; a display; and a micro-LED display.

### BACKGROUND ART

Various methods have been proposed to form displays containing red, green, and blue subpixels. As one of the methods, there is a method in which light from an LED array is converted through a color conversion structure such that blue light, having a shorter wavelength, is converted to red and green light, having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), there is a problem that, when transmittance at the exposure wavelength in the lithography process is ensured for forming the pattern, blue light that has not been color-converted by quantum dots and is transmitted appears on the outside when the light of a blue LED is applied to the cured film from below, and display clarity is degraded, since, generally, the absorbance of quantum dots is greater at the exposure wavelength in a lithography process than at the wavelength of blue LED light.

### CITATION LIST

### PATENT LITERATURE

Patent Document 1: JP 2021-089347 A

### SUMMARY OF INVENTION

### TECHNICAL PROBLEM

Full color is displayed by pixels each formed from the three primary colors constituted by the three kinds of subpixels consisting of subpixels in which a cured photoresist film containing quantum dots that emit red light is laminated on a blue LED, subpixels in which a cured photoresist film containing quantum dots that emit green light is laminated on a blue LED, and subpixels consisting of blue LEDs on which such films are not laminated, and if the cured photoresist films containing quantum dots transmit blue light, display in full color is difficult. To solve this problem, it is necessary to develop a material that can form a blue-light-absorption layer selectively, exclusively on the cured photoresist film containing quantum dots that emit red light and on the cured photoresist film containing quantum dots that emit green light, since blue emission cannot be obtained if such a layer is also laminated on subpixels consisting of blue LEDs on which cured photoresist films containing quantum dots are not laminated.

The present invention has been made in view of the above circumstances. An object of the present invention is to provide: a photosensitive resin composition capable of easily forming a film having high lithography resolution and favorable blue light absorption property; a photosensitive resin film and a photosensitive dry film obtained by using the photosensitive resin composition; patterning processes using these; and displays obtained by using the photosensitive resin composition.

### SOLUTION TO PROBLEM

To achieve the object, the present invention provides a photosensitive resin composition for absorbing blue LED light that has been transmitted through a cured photoresist film containing quantum dots capable of emitting red or green fluorescence, the composition comprising:
(A) an acrylic resin having a (meth)acryloyl group in a side chain;
(B) a dye having a maximum absorption wavelength at any wavelength of 490 to 430 nm;
(C) an oxime-based photo-radical generator;
(D) a surfactant; and
(E) a solvent.

Such a photosensitive resin composition is capable of easily forming a film having high lithography resolution and favorable blue light absorption property.

The component (A) is preferably an alkali-insoluble resin having a weight-average molecular weight Mw of 10,000 to 50,000, a double bond equivalent of ≤ 300 g/mol, and an acid value of ≤ 10 mg KOH/g.

When the acrylic resin (A) having a (meth)acryloyl group in a side chain has a weight-average molecular weight in the above-described range, film loss in exposed portions hardly occurs at the time of development, and the solubility of unexposed portions is favorable.

The component (B) is preferably contained in an amount of 0.5 to 15 mass% based on a non-volatile component of the photosensitive resin composition.

When the content percentage of the dye is within this range, fine pattern formation is possible while a favorable property of absorbing blue LED light is retained.

The composition preferably gives a cured film having a transmittance of 2% or less at a wavelength of 450 to 470 nm, a transmittance of 80% or more at a wavelength of 515 to 535 nm, and a transmittance of 80% or more at a wavelength of 620 to 640 nm, and having a film thickness of 1 to 10 µm.

Such a composition sufficiently transmits red light and green light, while a favorable property of absorbing blue light is achieved.

The present invention also provides a photosensitive resin film comprising a dried product of the above-described photosensitive resin composition.

Using the inventive photosensitive resin film, a photosensitive dry film can be manufactured.

The present invention also provides a photosensitive dry film comprising: a support film; and the above-described photosensitive resin film on the support film.

The inventive photosensitive dry film is capable of easily forming a film having high lithography resolution and favorable blue light absorption property.

The present invention also provides a patterning process comprising the steps of:
(i) applying the above-described photosensitive resin composition onto a substrate, the substrate comprising a pattern formed of a photoresist containing quantum dots capable of emitting red or green fluorescence, to form a photosensitive resin film on the substrate;
(ii) exposing the photosensitive resin film to light; and
(iii) developing the exposed photosensitive resin film with a developer to dissolve and remove an unexposed portion to form a pattern having a film thickness of 1 to 10 µm on the photoresist containing quantum dots.

Using the inventive photosensitive resin composition, a pattern having a desired shape can be formed.

It is preferable that post-baking is not performed after the step (ii).

In this manner, the cured photoresist film containing quantum dots underneath does not have unnecessary thermal history.

The present invention also provides a patterning process comprising the steps of:
(i') bonding the photosensitive resin film of the above-described photosensitive dry film to a substrate, the substrate comprising a pattern formed of a photoresist containing quantum dots capable of emitting red or green fluorescence, to form the photosensitive resin film on the substrate;
(ii') exposing the photosensitive resin film to light; and
(iii') developing the exposed photosensitive resin film with a developer to dissolve and remove an unexposed portion to form a pattern having a film thickness of 1 to 10 µm on the photoresist containing quantum dots.

Using the inventive photosensitive dry film, a pattern having a desired shape can be formed.

It is preferable that post-baking is not performed after the step (ii').

In this manner, the cured photoresist film containing quantum dots underneath does not have unnecessary thermal history.

The present invention also provides a display comprising: a blue LED; on the blue LED, a pattern formed of a photoresist containing quantum dots capable of emitting red or green fluorescence; and on the pattern, a pattern formed of a cured film of the above-described photosensitive resin composition, wherein the cured film absorbs blue LED light that has not been color-converted by the quantum dots to obtain from each subpixel only light that has been converted to red or green.

The inventive photosensitive resin composition can be used particularly suitably for such a purpose.

The present invention also provides a micro-LED display comprising: a blue LED; on the blue LED, a pattern formed of a photoresist containing quantum dots capable of emitting red or green fluorescence; and on the pattern, a pattern formed of a cured film of the above-described photosensitive resin composition, wherein the pattern formed of the cured film has a size of 0.01 mm² or less, and the cured film absorbs blue LED light that has not been color-converted by the quantum dots to obtain from each subpixel only light that has been converted to red or green.

The inventive photosensitive resin composition can be used particularly suitably for such a purpose.

The present invention also provides a laminate comprising: a photoresist containing quantum dots capable of emitting red or green fluorescence; and a cured film of the above-described photosensitive resin composition formed on the photoresist containing quantum dots.

The inventive laminate can be used suitably for manufacturing displays and micro-LED displays.

### ADVANTAGEOUS EFFECTS OF INVENTION

A film or a dry film formed from the inventive photosensitive resin composition can easily form, according to the inventive patterning process, a pattern that is fine and is excellent in verticality on a cured photoresist film containing quantum dots. Furthermore, an obtained cured film can absorb blue light that has been transmitted through the cured photoresist film containing quantum dots and can selectively obtain red light alone or green light alone, and therefore, can be used suitably for displays such as a micro-LED display.

### BRIEF DESCRIPTION OF DRAWINGS

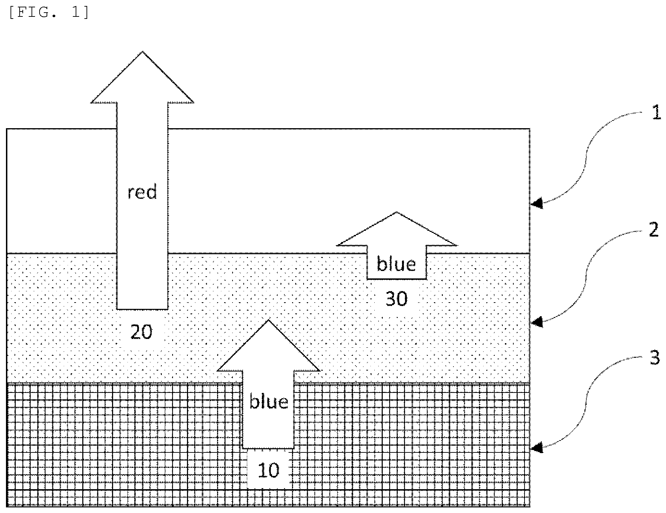

FIG. 1 is a schematic view for illustrating an example of the usage and function of the inventive photosensitive resin composition.

### DESCRIPTION OF EMBODIMENTS

As described above, there have been demands for the development of: a photosensitive resin composition capable of easily forming a film having high lithography resolution and favorable blue light absorption property; a photosensitive resin film and a photosensitive dry film obtained by using the photosensitive resin composition; patterning processes using these; and displays obtained by using the photosensitive resin composition.

The present inventors have earnestly studied to achieve the object and consequently found that the object can be achieved by a photosensitive resin composition containing certain components, and completed the present invention.

That is, the present invention is a photosensitive resin composition for absorbing blue LED light that has been transmitted through a cured photoresist film containing quantum dots capable of emitting red or green fluorescence, the composition comprising: (A) an acrylic resin having a (meth)acryloyl group in a side chain; (B) a dye having a maximum absorption wavelength at any wavelength of 490 to 430 nm; (C) an oxime-based photo-radical generator; (D) a surfactant; and (E) a solvent.

Hereinafter, the present invention will be described in detail, but the present invention is not limited thereto.

### [Photosensitive Resin Composition]

The inventive photosensitive resin composition is a photosensitive resin composition for absorbing blue LED light that has been transmitted through a cured photoresist film containing quantum dots capable of emitting red or green fluorescence, the composition comprising: (A) an acrylic resin having a (meth)acryloyl group in a side chain; (B) a dye having a maximum absorption wavelength at any wavelength of 490 to 430 nm; (C) an oxime-based photo-radical generator; (D) a surfactant; and (E) a solvent.

An example of the usage and function of the inventive photosensitive resin composition will be described with reference to FIG. 1. As shown in FIG. 1, on a blue LED 3, a cured photoresist film 2 containing quantum dots is disposed, and a cured film 1 of the inventive photosensitive resin composition is disposed thereon. Blue LED light 10 released from the blue LED 3 is converted to red fluorescence 20 by the quantum dots in the cured photoresist film 2 containing quantum dots. Then, the red fluorescence 20 is transmitted through the cured film 1 of the inventive photosensitive resin composition and released from the surface. Meanwhile, blue LED light 30 (part of the blue LED light 10), which has not been color-converted by the quantum dots, is absorbed by the dye (B) having a maximum absorption wavelength at a wavelength of 490 to 430 nm in the cured film 1 of the inventive photosensitive resin composition. That is, the cured film 1 of the inventive photosensitive resin composition eliminates the blue LED light that has remained without being color-converted, and thus, makes it possible to obtain red light selectively and efficiently. Incidentally, a case where red light is selectively obtained is explained in the above, but the same can be said for green light.

Furthermore, the inventive photosensitive resin composition preferably gives a cured film having a transmittance of 2% or less at a wavelength of 450 to 470 nm, a transmittance of 80% or more at a wavelength of 515 to 535 nm, and a transmittance of 80% or more at a wavelength of 620 to 640 nm, and having a film thickness of 1 to 10 µm. Alternatively, the inventive photosensitive resin composition preferably gives a cured film having a transmittance of 2% or less at at least part of the wavelengths of 450 to 470 nm, a transmittance of 80% or more at at least part of the wavelengths of 515 to 535 nm, and a transmittance of 80% or more at at least part of the wavelengths of 620 to 640 nm, and having a film thickness of 1 to 10 µm. In this manner, red light and green light can be sufficiently transmitted, while a favorable property of absorbing blue light can be achieved.

### [(A) Acrylic Resin Having (Meth)acryloyl Group in Side Chain]

The acrylic resin (a polymer of an acrylic acid ester or a methacrylic acid ester) (A) having a (meth)acryloyl group in a side chain used in the present invention is not particularly limited.

In the present invention, the acrylic resin (A) having a (meth)acryloyl group in a side chain preferably has a weight-average molecular weight Mw of 10,000 to 50,000, more preferably 15,000 to 40,000. When the acrylic resin (A) having a (meth)acryloyl group in a side chain has a weight-average molecular weight in the above ranges, film loss of exposed portions hardly occurs during development, and the solubility of unexposed portions in an organic solvent is favorable. The weight-average molecular weight is a value determined as a weight-average molecular weight (weight-average degree of polymerization) in terms of polystyrene measured by GPC (gel permeation chromatography) analysis using toluene as an eluent.

In the present invention, the acrylic resin (A) having a (meth)acryloyl group in a side chain preferably has a double bond equivalent of ≤ 300 g/mol, more preferably ≤ 280 g/mol. Note that a double bond equivalent is the weight of the resin per acrylic group. When the acrylic resin (A) having a (meth)acryloyl group in a side chain has a double bond equivalent in the above ranges, the crosslinking density is high, and it is possible to form a pattern having a favorable shape with high sensitivity after development.

In the present invention, the acrylic resin (A) having a (meth)acryloyl group in a side chain is preferably an alkali-insoluble resin having an acid value of ≤ 10 mg KOH/g. When the acrylic resin (A) is an alkali-insoluble resin having an acid value of ≤ 10 mg KOH/g, since hardly any acid groups are contained, post-baking for eliminating the acidic groups is not needed, and therefore, the cured photoresist film underneath containing quantum dots does not have unnecessary thermal history.

In the present invention, one kind of the acrylic resin (A) having a (meth)acryloyl group in a side chain may be used, or two or more kinds thereof may be used in combination. Furthermore, the acrylic resin (A) having a (meth)acryloyl group in a side chain is preferably contained in an amount of 40 to 99 mass% based on a non-volatile component of the photosensitive resin composition; further preferably 50 to 98 mass%.

Examples of the acrylic resin (A) having a (meth)acryloyl group in a side chain include "RA-3631P" (trade name) manufactured by Negami Chemical Industrial Co., Ltd. and "8KQ-7060" (trade name) of Taisei Fine Chemical Co., Ltd.

### [(B) Dye]

The dye (B) used in the present invention is not particularly limited as long as it has a maximum absorption wavelength at any wavelength of 490 to 430 nm, but preferably has favorable solubility or dispersibility in the solvent (E) and the acrylic resin (A) having a (meth)acryloyl group in a side chain.

The maximum absorption wavelength is determined in the following manner. Firstly, employing UV-vis (ultraviolet-visible) absorption spectroscopy, a sample is irradiated with ultraviolet rays or visible light, and in this event, while continuously scanning the irradiation wavelength, the quantity of light absorbed by the sample (absorbance) is measured. The measurement results are obtained as a graph (absorption spectrum) in which the wavelength is plotted on the horizontal axis and the absorbance is plotted on the vertical axis, and the wavelength at which the spectrum has the maximum value is defined as the maximum absorption wavelength.

As such a dye, a commercially available product can be used, and examples include FDB-002 (maximum absorption wavelength: 431 nm), FDB-003 (maximum absorption wavelength: 438 nm), FDB-004 (maximum absorption wavelength: 445 nm), FDB-005 (maximum absorption wavelength: 452 nm), and FDB-006 (maximum absorption wavelength: 473 nm) manufactured by Yamada Chemical Co., Ltd., FS Yellow 1017 (maximum absorption wavelength: 443 nm) manufactured by ARIMOTO CHEMICAL Co., Ltd., and Dye3 (maximum absorption wavelength: 464 nm) and Dye4 (maximum absorption wavelength: 479 nm) manufactured by Hayashibara Co., Ltd.

The dye (B) used in the present invention is preferably contained in an amount of 0.5 to 15 mass%, more preferably 1 to 10 mass% based on the non-volatile component of the photosensitive resin composition. When the content percentage of the dye is within these ranges, fine patterning is possible while a favorable property of absorbing blue LED light is retained.

### [(C) Oxime-Based Photo-Radical Generator]

The oxime-based photo-radical generator used in the present invention is not particularly limited as long as it is an oxime compound for enhancing the sensitivity at the time of lithography.

Examples of the oxime compound include compounds of N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazol-3-yl]ethane-1-imine, N-acetoxy-1-[9-ethyl-6-{2-methyl-4-(3,3-dimethyl-2,4-dioxacyclopentanylmethyloxy)benzoyl}-9H-carbazol-3-yl]ethane-1-imine, N-acetoxy-1-[9-ethyl-6-(2-methylbenzoyl)-9H-carbazol-3-yl]-3-cyclopentylpropane-1-imine, and N-benzoyloxy-1-[9-ethyl-6-(2-methylbenzoyl)-9H-carbazol-3-yl]-3-cyclopentylpropan-1-one-2-imine. It is also possible to use commercially available products such as Irgacure OXE01 and OXE02 (manufactured by BASF Corporation) and ADEKA ARKLS NCI-930 and NCI-730 (manufactured by ADEKA CORPORATION).

The oxime-based photo-radical generator (C) used in the present invention is preferably contained in an amount of 0.1 to 10 mass%, more preferably 0.5 to 7 mass% based on the non-volatile component of the photosensitive resin composition. When the content percentage of the oxime-based photo-radical generator is in the above-described ranges, fine pattern formation is possible while favorable luminous properties are retained.

### [(D) Surfactant]

The surfactant (D) used in the present invention is not particularly limited as long as it can enhance coating property, but is preferably a silicone-based surfactant.

Examples of silicone-based surfactants include surfactants having a siloxane bond in the molecule. Specific examples thereof include Toray Silicone DC3PA, SH7PA, DC11PA, SH21PA, SH28PA, SH29PA, SH30PA, SH8400 (trade names, manufactured by Dow Toray Co., Ltd.), KP321, KP322, KP323, KP324, KP326, KP340, KP341 (manufactured by Shin-Etsu Chemical Co., Ltd.), TSF400, TSF401, TSF410, TSF4300, TSF4440, TSF4445, TSF4446, TSF4452, and TSF4460 (manufactured by Momentive Performance Materials Japan LLC).

The surfactant (D) used in the present invention is preferably contained in an amount of 0.001 to 0.7 mass%, more preferably 0.005 to 0.5 mass^{®} based on the non-volatile component of the photosensitive resin composition. When the content percentage of the surfactant is in the above-described ranges, it is possible to form a film that is highly flat.

### [(E) Solvent]

The solvent (E) used in the present invention is not particularly limited, as long as it can dissolve and disperse the above-described components (A) to (D) and other various additives if contained.

The solvent (E) is preferably an organic solvent. Examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; etc. One of these may be used, or two or more thereof may be used in mixture.

The solvent (E) is preferably propylene glycol monomethyl ether acetate, propylene glycol monomethyl ether, cyclopentanone, or a mixed solvent thereof because of excellent solubility for the acrylic resin (A) having a (meth)acryloyl group in a side chain.

The component (E) is preferably contained in an amount of 25 to 85 mass%, more preferably 35 to 75 mass% based on the total amount of the photosensitive resin composition from the viewpoints of compatibility and viscosity of the photosensitive resin composition.

### [Other Additives]

The inventive photosensitive resin composition may contain other additives, besides the above-described components. Examples of other additives include a photopolymerizable compound, such as a polyfunctional (meth) acrylate, for the purpose of enhancing crosslinking density to form a pattern having a favorable shape after development.

### [Silane Coupling Agent]

The inventive photosensitive resin composition preferably does not contain a silane coupling agent, although there is not particular limitation thereto. When no silane coupling agent is contained, it is possible further to reduce the risk that the viscosity of the photosensitive resin composition increases over time and storage stability becomes degraded. The cause of the increase in viscosity over time is not fully understood, but is thought to be likely to be the hydroxy groups in the side chains of the acrylic resin being crosslinked to each other in the side chains.

### [Photosensitive Resin Film]

The inventive photosensitive resin film is a dried product of the above-described photosensitive resin composition.

### [Patterning Process Using Photosensitive Resin Composition]

A patterning process using the inventive photosensitive resin composition includes the steps of:
(i) applying the photosensitive resin composition onto a substrate, the substrate including a pattern formed of a photoresist containing quantum dots capable of emitting red or green fluorescence, to form a photosensitive resin film on the substrate;
(ii) exposing the photosensitive resin film to light; and
(iii) developing the exposed photosensitive resin film with a developer to dissolve and remove an unexposed portion to form a pattern having a film thickness of 1 to 10 µm on the photoresist containing quantum dots.

Furthermore, it is preferable that post-baking is not performed after the step (ii).

The step (i) is a step in which the photosensitive resin composition is applied onto a substrate provided with a pattern formed of a photoresist containing quantum dots capable of emitting red or green fluorescence to form a photosensitive resin film on the substrate. The photosensitive resin film is a dried product of the above-described photosensitive resin composition.

The application method can be a known method. Examples thereof include a dipping method, a spin coating method, a roll coating method, etc. The application amount can be appropriately selected in accordance with the purpose.

In this case, the solvent or the like may be preliminary evaporated by pre-heating (pre-baking) as necessary for efficient photo-curing reaction. The pre-baking can be performed, for example, at 60 to 120°C for about 1 minute to 1 hour.

Then, in the step (ii), the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; far ultraviolet light (248 nm, 193 nm); etc. Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Note that the material of the photomask is not particularly limited, but is preferably one that blocks light with the aforementioned wavelength. For example, a photomask including a light-blocking film made of chromium is suitably used, but is not limited thereto.

Then, in the step (iii), after the exposure, development is performed with a developer to form a pattern. Preferable examples of the developer include organic solvents such as: alcohols, such as IPA; ketones, such as cyclohexanone; glycols, such as propylene glycol monomethyl ether; etc. Examples of the development method include usual methods, for example, a dipping method in which the patterned substrate is soaked into the developer; a puddle method in which the developer is dispensed by puddle; and a spraying method in which the developer is applied by spraying. By performing the development in this manner, the unexposed portion is dissolved and removed, so that a pattern is formed. Then, if necessary, washing, rinsing, drying, and so forth are carried out to give a cured film having a desired pattern.

### [Photosensitive Dry Film]

The inventive photosensitive dry film includes: a support film; and a photosensitive resin film formed on the support film, the photosensitive resin film being obtained from the photosensitive resin composition.

The photosensitive dry film (a support film and a photosensitive resin film) is solid, and the photosensitive resin film does not contain a solvent. Accordingly, bubbles due to the volatilization of the solvent will not remain in the photosensitive resin film and between this film and an uneven substrate.

In addition, at a high temperature, the viscosity and fluidity of the photosensitive resin film are closely related. The photosensitive resin film can exhibit appropriate fluidity in an appropriate viscosity range; the photosensitive resin film deeply enters into a narrow gap and the resin softens, so that the adhesion to a substrate can be enhanced. Thus, the viscosity of the photosensitive resin film at a high temperature is preferably 10 to 5,000 Pa·s, more preferably 30 to 2,000 Pa·s at 80°C from the viewpoint of the fluidity of the photosensitive resin film. Note that, in the present invention, the viscosity is a value measured with a rotational viscometer.

When the inventive photosensitive dry film is brought into close contact with an uneven substrate, the photosensitive resin film fits in and covers the unevenness, so that high flatness can be achieved. Particularly, the inventive photosensitive resin composition has softening performance, so that higher planarization can be achieved. Further, bringing the photosensitive resin film into close contact with the substrate under vacuum environment makes it possible to more effectively prevent a gap therebetween.

The inventive photosensitive dry film can be produced by applying the photosensitive resin composition onto a support film, and drying the composition to form a photosensitive resin film. As the production apparatus for the photosensitive dry film, it is possible to employ a film coater which is commonly used to produce adhesive products. Examples of the film coater include a comma coater, a comma reverse coater, a multi coater, a die coater, a lip coater, a lip reverse coater, a direct gravure coater, an offset gravure coater, a 3-roll bottom reverse coater, a 4-roll bottom reverse coater, etc.

When the support film is rolled-out from a roll-out shaft of the film coater and passes through a coater head of the film coater, the photosensitive resin composition is applied to have a predetermined thickness onto the support film; then, the resultant is passed through a hot-air circulating oven at a predetermined temperature for a predetermined period to dry and form the photosensitive resin film on the support film, so that the photosensitive dry film can be produced. It is also possible to produce the photosensitive dry film having a protective film in accordance with need by: passing the photosensitive dry film through a laminate roll under a predetermined pressure together with the protective film that has been rolled-out from another roll-out shaft of the film coater, thereby bonding the protective film to the photosensitive resin film on the support film; and subsequently winding up the resulting laminate to a winding shaft of the film coater. In this case, the temperature is preferably 50 to 120°C, the period is preferably 1 to 100 minutes, and the pressure is preferably 0.01 to 5 MPa.

The support film used in the inventive photosensitive dry film may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include Cerapeel WZ (RX) and Cerapeel BX8 (R) (both are manufactured by Toray Advanced Film Co., Ltd.), E7302 and E7304 (both are manufactured by Toyobo Co., Ltd.), Purex G31 and Purex G71T1 (both are manufactured by Teijin DuPont Films Japan Ltd.), PET38×1-A3, PET38×1-V8, and PET38×1-X08 (all manufactured by Nippa Co., Ltd.), etc.

The protective film to be used may be the same film as the above-mentioned support film, but polyethylene terephthalate and polyethylene having appropriate flexibility are preferred. Commercial products may be used for these. Examples thereof include the polyethylene terephthalates that have already been exemplified; polyethylenes, such as GF-8 (manufactured by Tamapoly Co., Ltd.) and PE Film 0-Type (manufactured by Nippa Co., Ltd.); etc.

The thicknesses of both the support film and the protective film are preferably 10 to 100 µm, more preferably 25 to 50 µm, from the viewpoints of stable production of the photosensitive dry film and the rolling habit around a roll shaft, what is called curl-prevention.

### [Patterning Process using Photosensitive Dry Film]

A patterning process using the inventive photosensitive dry film includes the steps of:
(i') bonding the photosensitive resin film of the photosensitive dry film to a substrate, the substrate including a pattern formed of a photoresist containing quantum dots capable of emitting red or green fluorescence, to form the photosensitive resin film on the substrate;
(ii') exposing the photosensitive resin film to light; and
(iii') developing the exposed photosensitive resin film with a developer to dissolve and remove an unexposed portion to form a pattern having a film thickness of 1 to 10 µm on the photoresist containing quantum dots.

Furthermore, it is preferable that post-baking is not performed after the step (ii').

First, in the step (i'), the photosensitive dry film is used to bond the photosensitive resin film to a substrate provided with a pattern formed of a photoresist containing quantum dots capable of emitting red or green fluorescence to form the photosensitive resin film on the substrate. Specifically, the photosensitive resin film of the photosensitive dry film is bonded to the substrate, so that the photosensitive resin film is formed on the substrate. Meanwhile, in the case where the photosensitive dry film has a protective film, after the protective film is peeled from the photosensitive dry film, the photosensitive resin film of the photosensitive dry film is bonded to the substrate. The bonding can be performed, for example, by using a film-bonding apparatus.

The film-bonding apparatus is preferably a vacuum laminator. For example, the protective film of the photosensitive dry film is delaminated, and the uncovered photosensitive resin film is brought into close contact with the substrate on a table at a predetermined temperature by using a bonding roll under a predetermined pressure in a vacuum chamber with a predetermined degree of vacuum. It is to be noted that the temperature is preferably 60 to 120°C, the pressure is preferably 0 to 5.0 MPa, and the degree of vacuum is preferably 50 to 500 Pa.

For efficient photo-curing reaction of the photosensitive resin film and for adhesiveness enhancement between the photosensitive resin film and the substrate, pre-baking may be performed as necessary. The pre-baking can be performed, for example, at 60 to 120°C for about 1 minute to 1 hour.

The photosensitive resin film adhered on the substrate can be subjected to (ii') the step of exposing the photosensitive resin film to light, and (iii') the step of developing the exposed photosensitive resin film with a developer to dissolve and remove an unexposed portion for patterning to form a pattern as in the case of the patterning process using the photosensitive resin composition. Note that the support film of the photosensitive dry film is delaminated before the development step, depending on the process.

The patterning processes using the inventive photosensitive resin composition or dry film make it possible to easily form fine patterns selectively on patterns formed of a photoresist containing quantum dots capable of emitting red or green fluorescence.

### [Display and Micro-LED Display]

The present invention also provides a display including: a blue LED; on the blue LED, a pattern formed of a photoresist containing quantum dots capable of emitting red or green fluorescence; and on the pattern, a pattern formed of a cured film of the above-described photosensitive resin composition, where the cured film absorbs blue LED light that has not been color-converted by the quantum dots to obtain from each subpixel only light that has been converted to red or green.

As a resist for forming the cured film, a known negative or positive resist can be selected, and a negative resist is preferable. For example, compositions disclosed in JP 2021-089347 A are preferable.

Furthermore, the present invention also provides a micro-LED display including: a blue LED; on the blue LED, a pattern formed of a photoresist containing quantum dots capable of emitting red or green fluorescence; and on the pattern, a pattern formed of a cured film of the above-described photosensitive resin composition, where the pattern formed of the cured film has a size of 0.01 mm² or less, and the cured film absorbs blue LED light that has not been color-converted by the quantum dots to obtain from each subpixel only light that has been converted to red or green.

The inventive display is, for example, a micro-LED display in which a cured film obtained by a patterning process described above absorbs blue LED light that has not been color-converted by the quantum dots to obtain from each subpixel only light that has been converted to red or green. The present invention is also applicable to mini-LEDs.

### [Laminate]

The present invention also provides a laminate including: a photoresist containing quantum dots capable of emitting red or green fluorescence; and a cured film of the above-described photosensitive resin composition formed on the photoresist containing quantum dots. The inventive laminate can be used suitably for manufacturing displays and micro-LED displays.

### EXAMPLES

Hereinafter, the present invention will be more specifically described with reference to Examples and Comparative Examples. However, the present invention is not limited to the following Examples.

### [1] Preparation of Photosensitive Resin Composition and Evaluation Thereof

### [Examples 1 to 6 and Comparative Examples 1 to 12]

Each component was blended according to the formulation amount shown in Tables 1 to 3, then, the components were stirred and mixed at normal temperature, and micro-filtering was performed with a 1.0-µm glass filter to obtain photosensitive resin compositions (solutions in PGMEA) of Examples 1 to 6 and Comparative Examples 1 to 12. Note that, in the tables, the amounts are shown in such a manner that the total amount of the solid contents (components other than the solvent (E)) is 100.

**[Table 1]**

| Component | | | Example | | | | | |
|---|---|---|---|---|---|---|---|---|
| | | | 1 | 2 | 3 | 4 | 5 | 6 |
| A | Resin | A-1 | 82.7 | 91.7 | | | 93.8 | |
| | | A-2 | | | 97.8 | 96.3 | | 93.8 |
| | | A'-1 | | | | | | |
| B | Dye | B-1 | 10 | | | | | |
| | | B-2 | | 5 | | | | |
| | | B-3 | | | 1 | | 3 | |
| | | B-4 | | | | 3 | | 5 |
| | | B'-1 | | | | | | |
| | | B'-2 | | | | | | |
| | | B'-3 | | | | | | |
| C | Photo-radical generator | C-1 | 7 | | 1 | | 3 | |
| | | C-2 | | 3 | | 0.5 | | 1 |
| | | C' -1 | | | | | | |
| | | C' -2 | | | | | | |
| | | C' -3 | | | | | | |
| D | Surfactant | D-1 | 0.3 | 0.3 | 0.2 | 0.2 | 0.2 | 0.2 |
| E | Solvent | PGMEA | 100 | 100 | 100 | 100 | 67 | 67 |

**[Table 2]**

| Component | | | Comparative Example | | | | | | | |
|---|---|---|---|---|---|---|---|---|---|---|
| | | | 1 | 2 | 3 | 4 | 5 | 6 | 7 | 8 |
| A | Resin | A-1 | 87.7 | | 93.7 | | 91.7 | | | |
| | | A-2 | | 97.7 | | 86.7 | | 91.7 | | |
| | | A'-1 | | | | | | | 91.7 | 96.3 |
| B | Dye | B-1 | | | | | | | | |
| | | B-2 | 5 | | | | | | 5 | |
| | | B-3 | | 1 | | | | | | |
| | | B-4 | | | 3 | | | | | 3 |
| | | B'-1 | | | | 10 | | | | |
| | | B'-2 | | | | | 5 | | | |
| | | B'-3 | | | | | | 5 | | |
| C | Photo-radical generator | C-1 | | | | | | | | |
| | | C-2 | | | | 3 | 3 | 3 | 3 | 0.5 |
| | | C'-1 | 7 | | | | | | | |
| | | C'-2 | | 1 | | | | | | |
| | | C'-3 | | | 3 | | | | | |
| D | Surfactant | D-1 | 0.3 | 0.3 | 0.3 | 0.3 | 0.3 | 0.3 | 0.3 | 0.2 |
| E | Solvent | PGMEA | 100 | 100 | 100 | 100 | 100 | 100 | 100 | 100 |

**[Table 3]**

| Component | | | Comparative Example | | | |
|---|---|---|---|---|---|---|
| | | | 9 | 10 | 11 | 12 |
| A | Resin | A'-2 | 83.0 | 92.0 | 98.0 | 96.5 |
| B | Dye | B-1 | 10 | | | |
| | | B-2 | | 5 | | |
| | | B-3 | | | 1 | |
| | | B-4 | | | | 3 |
| F | Photo-acid generator | F-1 | 7 | 3 | 1 | 0.5 |
| G | Epoxy crosslinking agent | G-1 | | 38.8 | | 39.8 |
| E | Solvent | PGMEA | 100 | 139 | 100 | 140 |

In Tables 1 to 3, A-1 is "RA-3631P" (trade name) (acrylic resin, Mw: 18,000, acid value: 5 mg KOH/g, double bond equivalent: 250 g/mol) manufactured by Negami Chemical Industrial Co., Ltd., A-2 is "8KQ-7060" (trade name) (acrylic resin, Mw: 33,000, acid value: 10 mg KOH/g, double bond equivalent: 260 g/mol) of Taisei Fine Chemical Co., Ltd., and A'-1 is "PH-9001" (trade name) (urethane resin, Mw: 20,000, acid value: 41 mg KOH/g, double bond equivalent: 890 g/mol) of Taisei Fine Chemical Co., Ltd.

In Tables 1 to 3, B-1 is FDB-002 (maximum absorption wavelength: 431 nm) manufactured by Yamada Chemical Co., Ltd., B-2 is FS Yellow 1017 (maximum absorption wavelength: 443 nm) manufactured by ARIMOTO CHEMICAL Co., Ltd., B-3 is FDB-005 (maximum absorption wavelength: 452 nm) manufactured by Yamada Chemical Co., Ltd., B-4 is FDB-006 (maximum absorption wavelength: 473 nm) manufactured by Yamada Chemical Co., Ltd., B'-1 is FDB-009 (maximum absorption wavelength: 402 nm) manufactured by Yamada Chemical Co., Ltd., B'-2 is FDG-001 (maximum absorption wavelength: 503 nm) manufactured by Yamada Chemical Co., Ltd., and B'-3 is FDR-001 (maximum absorption wavelength: 604 nm) manufactured by Yamada Chemical Co., Ltd.

In Tables 1 to 3, C-1 is "Irgacure OXE01" (trade name) (oxime ester-based) manufactured by BASF Corporation, C-2 is "ADEKA ARKLS NCI-730" (trade name) (oxime ester-based) manufactured by ADEKA CORPORATION, C'-1 is "Irgacure 184" (trade name) (hydroxyalkylphenone-based) manufactured by BASF Corporation, C'-2 is "Irgacure 819" (trade name) (acyl phosphine oxide-based) manufactured by BASF Corporation, and C'-3 is "Irgacure 369" (trade name) (aminoalkylphenone-based) manufactured by BASF Corporation.

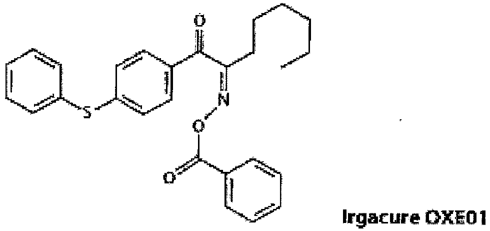

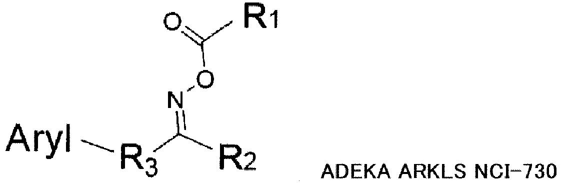

In Tables 1 to 3, D-1 is "KP341" (trade name) (polyether-type silicon-based surfactant) manufactured by Shin-Etsu Chemical Co., Ltd.

As A'-2 in Tables 1 to 3, a material synthesized in the following manner was used. Into a 3-L flask equipped with a stirrer, a thermometer, a nitrogen inflow instrument, and a reflux condenser, 265.0 g (1.00 mol) of the following Compound (S-5) was introduced. Then, 2,000 g of toluene was added thereto, and the mixture was heated to 70°C. Subsequently, 1.0 g of a solution of chloroplatinic acid in toluene (platinum concentration: 0.5 mass%) was introduced, and 164.9 g (0.85 mol) of the following Compound (S-1) and 453.0 g (0.15 mol) of the following Compound (S-2) (y¹=40, manufactured by Shin-Etsu Chemical Co., Ltd.) were added dropwise over 1 hour (total of hydrosilyl groups/total of alkenyl groups=1/1 (molar ratio)). After completion of the dropwise addition, the mixture was heated to 100°C and aged for 6 hours. Thereafter, toluene was evaporated from the reaction solution under reduced pressure. Thus, Resin A'-2 with an Mw of 65,000 was obtained.

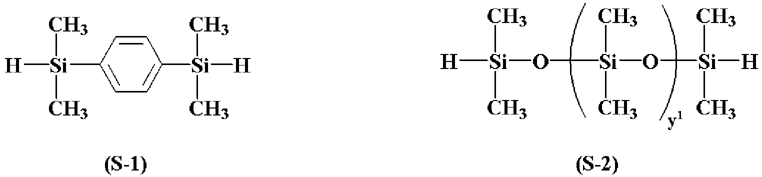

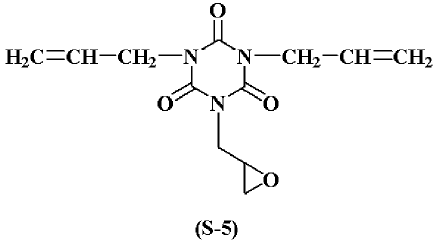

As the Photo-Acid Generator F-1 in Tables 1 to 3, "CPI-210S" (trade name) of San-Apro Ltd. was used.

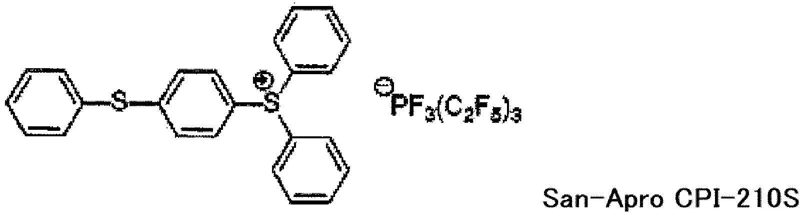

In Tables 1 to 3, the Epoxy Crosslinking Agent G-1 is as follows.

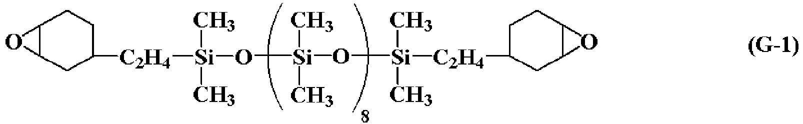

### [2] Preparation of Photosensitive Dry Films

Using a die coater as a film coater, each of the photosensitive resin compositions shown in Tables 1 to 3 was applied onto a support film which was a polyethylene terephthalate film (thickness: 38 µm). Then, the resultant was dried by passing, for 5 minutes, through a hot-air circulating oven (length: 4 m) set at 80°C. Thereby, a photosensitive resin film was formed on the support film to have a thickness of 5 µm, and a photosensitive dry film was obtained. Onto the photosensitive resin film, a polyethylene film (thickness: 50 µm) as a protective film was bonded using a laminate roll at a pressure of 1 MPa. In this manner, a photosensitive dry film with a protective film was prepared. The protective film of the prepared dry film was peeled. In this event, when it was visually observed that there was even one portion where the photosensitive resin film had adhered to the protective film and had been detached from the base material film, the evaluation "Bad" was given, and when no problems occurred, the evaluation "Good" was given. The results are shown in Tables 4 to 9.

### [3] Transmittance of Cured Film at Each Wavelength

The protective film was peeled from the photosensitive dry film with a protective film, and the photosensitive resin film on the support film was respectively brought into close contact with a glass wafer by using a vacuum laminator TEAM-100RF (manufactured by Takatori Corporation) with the degree of vacuum in the vacuum chamber set to 80 Pa. The temperature condition was set to 100°C. The pressure was restored to normal pressure, then the substrate was taken out of the vacuum laminator, and the support film was peeled. Subsequently, to enhance the adhesion to the substrate, pre-baking was performed with a hot plate at 100°C for 2 minutes. The obtained photosensitive resin film was exposed using an i-line stepper NSR-2205i11D (manufactured by Nikon Corporation) via a mask. After irradiation, spray development was performed with PGMEA for 20 seconds to form a 4-cm square island pattern. In this event, using a spectrophotometer U-3900H (manufactured by Hitachi High-Tech Corporation), the transmittance of the cured film was measured at 450 to 470 nm, 515 to 535 nm, and 620 to 640nm. When the cured film satisfied a transmittance of 2% or less at 450 to 470 nm, a transmittance of 80% or more at 515 to 535 nm, and a transmittance of 80% or more at 620 to 640 nm, the evaluation "Good" was given, and when the cured film did not satisfy these conditions, the evaluation "Bad" was given. The results are shown in Tables 4 to 9.

### [4] Pattern Formation and Evaluation Thereof

Firstly, underlying substrates each provided with a pattern formed of a photoresist containing quantum dots capable of emitting red or green fluorescence were prepared. The components A'-2, F-1, S-BE030 (maximum fluorescence wavelength: 635 nm) manufactured by SHOEI CHEMICAL INC., G-1, CHIMASSORB 119FL manufactured by BASF Corporation, IRGANOX 3114 manufactured by BASF Corporation, and cyclopentanone were blended at the blending amounts of 100:1:100:30:0.1:0.1:231, then, the components were stirred and mixed at normal temperature, and micro-filtering was performed with a 1.0-µm glass filter to obtain a Photoresist R containing quantum dots. Meanwhile, the S-BE030 was substituted with S-BE029 (maximum fluorescence wavelength: 535 nm) manufactured by SHOEI CHEMICAL INC. to obtain a Photoresist G containing quantum dots. Subsequently, the Photoresist R or G containing quantum dots was respectively applied onto a glass substrate with a film thickness of 10 µm by using a spin coater. Subsequently, pre-baking was performed with a hot plate at 100°C for 2 minutes. The obtained film was exposed using an i-line stepper NSR-2205i11D (manufactured by Nikon Corporation) via a mask. After irradiation, spray development was performed with PGMEA for 60 seconds to form a 4-cm square island pattern. After that, post-curing was performed using an oven at 150°C for 2 hours while the oven was purged with nitrogen. Thus, underlying substrates each including a pattern formed of a photoresist containing quantum dots capable of emitting red or green fluorescence were prepared.

The protective film was peeled from the photosensitive dry film with a protective film, and the photosensitive resin film on the support film was respectively brought into close contact with the substrate each provided with the pattern formed of the photoresist containing quantum dots capable of emitting red or green fluorescence by using a vacuum laminator TEAM-100RF (manufactured by Takatori Corporation) with the degree of vacuum in the vacuum chamber set to 80 Pa. The temperature condition was set to 100°C. The pressure was restored to normal pressure, then the substrate was taken out of the vacuum laminator, and the support film was peeled. Subsequently, to enhance the adhesion to the substrate, pre-baking was performed with a hot plate at 100°C for 2 minutes. Exposure was performed using an i-line stepper NSR-2205i11D (manufactured by Nikon Corporation) to form a square island pattern on the obtained photosensitive resin films via a mask in such a manner as to achieve a pitch width of 1:1 between adjacent patterns. After irradiation, spray development was performed with PGMEA for 20 seconds to form a pattern on the cured photoresist film containing quantum dots. After that, the formed 50-µm, 20-µm, 10-µm, 5-µm, and 3-µm square island patterns were observed with a scanning electron microscope (SEM), and the minimum pattern size at which adjacent island patterns (pitch width: 1:1) were not joined was obtained as the threshold resolution. When the resolution did not reach 50 µm, the evaluation "Bad" was given. In addition, the verticality of the patterns was evaluated, and a vertical pattern was evaluated as "Good", and a tapered shape or opening failure was evaluated as "Bad". The results are shown in Tables 4 to 9.

### [5] Chromaticity Measurement

Using, as substrates, the above-described substrates each including the pattern formed of the photoresist containing quantum dots capable of emitting red or green fluorescence, a 4-cm square island pattern was formed on the cured photoresist film containing quantum dots by using the photosensitive resin compositions of Examples 1 to 6 and Comparative Examples 1 to 12 in the same manner as above. After that, chromaticity measurement was performed from the front side by using an illuminance spectrophotometer MK350S PREMIUM (manufactured by UPRtek) while applying blue LED light from the reverse side of the substrate. The evaluation is "Red" when x ≥ 0.5 (red region), "Green" when y ≥ 0.5 (green region), and "Bad" in other cases. Note that the results of the chromaticity measurement of the substrate itself, including the pattern formed of the photoresist containing quantum dots capable of emitting red fluorescence, are shown as Ref. R, and the results of the chromaticity measurement of the substrate itself, including the pattern formed of the photoresist containing quantum dots capable of emitting green fluorescence, are shown as Ref. G. The results are shown in Tables 4 to 9.

### [6] Light Resistance Test

Using the substrates that had been subjected to the above-described chromaticity measurement, a sunlight light resistance test was performed with Atlas SUNTEST XLS+, manufactured by Toyo Seiki Seisaku-sho, Ltd., for 500 hours under conditions of illuminance of 65 W/m² and an environmental temperature of 100°C, and chromaticity measurement was performed again. When the variation in "x" or "y" between before and after the light resistance test was ≥ 0.03, the evaluation "Bad" was given, and when less than that, "Good". Note that the results of the chromaticity measurement of the substrate itself, including the pattern formed of the photoresist containing quantum dots capable of emitting red fluorescence, are shown as Ref. R, and the results of the chromaticity measurement of the substrate itself, including the pattern formed of the photoresist containing quantum dots capable of emitting green fluorescence, are shown as Ref. G. The results are shown in Tables 4 to 9.

### [7] Adhesiveness Test

Using the substrates that had been subjected to the above-described chromaticity measurement, a crosscut peel test (JIS K5400) was performed. When there was even one peeled portion as a result, the evaluation "Bad" was given, and when there were no peeled portions at all, "Good". The results are shown in Tables 4 to 9.

**[Table 4]**

| | Example | | | | | |
|---|---|---|---|---|---|---|
| | 1 | 2 | 3 | 4 | 5 | 6 |
| Dry film cover film peeling property | Good | Good | Good | Good | Good | Good |
| Transmittance evaluation at each wavelength | Good | Good | Good | Good | Good | Good |

**[Table 5]**

| | Comparative Example | | | | | | | | | | | |
|---|---|---|---|---|---|---|---|---|---|---|---|---|
| | 1 | 2 | 3 | 4 | 5 | 6 | 7 | 8 | 9 | 10 | 11 | 12 |
| Dry film cover film peeling property | Bad | Bad | Bad | Bad | Bad | Bad | Bad | Bad | Good | Good | Good | Good |
| Transmittance evaluation at each wavelength | Good | Good | Good | Bad | Bad | Bad | Good | Good | Good | Good | Good | Good |

**[Table 6]**

| Case where substrate with pattern formed of R was used as underlying substrate | | Example | | | | | |
|---|---|---|---|---|---|---|---|
| | | 1 | 2 | 3 | 4 | 5 | 6 |
| Pattern | Threshold resolution/µm | 3 | 3 | 3 | 3 | 3 | 3 |
| | Shape | Good | Good | Good | Good | Good | Good |
| Chromaticity measurement | | Red | Red | Red | Red | Red | Red |
| Change in chromaticity after light resistance test | | Good | Good | Good | Good | Good | Good |
| Adhesiveness | | Good | Good | Good | Good | Good | Good |

**[Table 7]**

| Case where substrate with pattern formed of R was used as underlying substrate | | Comparative Example | | | | | | | | | | | | |
|---|---|---|---|---|---|---|---|---|---|---|---|---|---|---|
| | | 1 | 2 | 3 | 4 | 5 | 6 | 7 | 8 | 9 | 10 | 11 | 12 | Ref. R |
| Pattern | Threshold resolution/µm | Bad | Bad | Bad | Bad | 20 | 20 | Bad | Bad | Bad | Bad | Bad | Bad | - |
| | Shape | Bad | Bad | Bad | Bad | Bad | Bad | Bad | Bad | Bad | Bad | Bad | Bad | - |
| Chromaticity measurement | | Red | Red | Red | Bad | Bad | Bad | Red | Red | Red | Red | Red | Red | Bad |
| Change in chromaticity after light resistance test | | Bad | Bad | Bad | Bad | Bad | Bad | Bad | Bad | Bad | Bad | Bad | Bad | Bad |
| Adhesiveness | | Bad | Bad | Bad | Bad | Bad | Bad | Bad | Bad | Bad | Bad | Bad | Bad | Bad |

**[Table 8]**

| Case where substrate with pattern formed of G was used as underlying substrate | | Example | | | | | |
|---|---|---|---|---|---|---|---|
| | | 1 | 2 | 3 | 4 | 5 | 6 |
| Pattern | Threshold resolution/µm | 3 | 3 | 3 | 3 | 3 | 3 |
| | Shape | Good | Good | Good | Good | Good | Good |
| Chromaticity measurement | | Green | Green | Green | Green | Green | Green |
| Change in chromaticity after light resistance test | | Good | Good | Good | Good | Good | Good |
| Adhesiveness | | Good | Good | Good | Good | Good | Good |

**[Table 9]**

| Case where substrate with pattern formed of G was used as underlying substrate | | Comparative Example | | | | | | | | | | | | |
|---|---|---|---|---|---|---|---|---|---|---|---|---|---|---|
| | | 1 | 2 | 3 | 4 | 5 | 6 | 7 | 8 | 9 | 10 | 11 | 12 | Ref. G |
| Pattern | Threshold resolution/µm | Bad | Bad | Bad | Bad | 20 | 20 | Bad | Bad | Bad | Bad | Bad | Bad | - |
| | Shape | Bad | Bad | Bad | Bad | Bad | Bad | Bad | Bad | Bad | Bad | Bad | Bad | - |
| Chromaticity measurement | | Green | Green | Green | Bad | Bad | Bad | Green | Green | Green | Green | Green | Green | Bad |
| Change in chromaticity after light resistance test | | Bad | Bad | Bad | Bad | Bad | Bad | Bad | Bad | Bad | Bad | Bad | Bad | Bad |
| Adhesiveness | | Bad | Bad | Bad | Bad | Bad | Bad | Bad | Bad | Bad | Bad | Bad | Bad | Bad |

As shown in Tables 4 to 9, regarding Examples 1 to 6, being inventive photosensitive resin compositions, the photosensitive resin film was successfully peeled from the protective film, blue LED light was successfully selectively eliminated, it was possible to form a vertical pattern with high resolution, blue light absorption property was also favorable and sustainable, and adhesiveness was also favorable. On the other hand, regarding Comparative Examples 1 to 12, being photosensitive resin compositions missing any one of the acrylic resin (A) having a (meth)acryloyl group in a side chain, the dye (B) having a maximum absorption wavelength at a wavelength of 490 to 430 nm, and the oxime-based photo-radical generator (C), pattern formation, durability of blue light absorption property, and adhesiveness were poor in every case. In addition, regarding Comparative Examples 1 to 8, peeling property from the protective film was also poor.

From the above results, the inventive photosensitive resin composition can form a favorable photosensitive film and a favorable photosensitive dry film and has lithography performance that makes it possible to form easily a pattern that is fine and excellent in verticality on a cured photoresist film containing quantum dots. In addition, the obtained cured film absorbs blue light that has been transmitted through the cured photoresist film containing quantum dots, is capable of obtaining only red or green light selectively and efficiently, and can provide high light resistance that does not affect chromaticity. Therefore, the inventive composition can be used suitably for displays, such as micro-LED displays.

The present description includes the following inventions.
[1]: A photosensitive resin composition for absorbing blue LED light that has been transmitted through a cured photoresist film containing quantum dots capable of emitting red or green fluorescence, the composition comprising:
   (A) an acrylic resin having a (meth)acryloyl group in a side chain;
   (B) a dye having a maximum absorption wavelength at any wavelength of 490 to 430 nm;
   (C) an oxime-based photo-radical generator;
   (D) a surfactant; and
   (E) a solvent.
[2]: The photosensitive resin composition according to [1], wherein the component (A) is an alkali-insoluble resin having a weight-average molecular weight Mw of 10,000 to 50,000, a double bond equivalent of ≤ 300 g/mol, and an acid value of ≤ 10 mg KOH/g.
[3]: The photosensitive resin composition according to [1] or [2], wherein the component (B) is contained in an amount of 0.5 to 15 mass% based on a non-volatile component of the photosensitive resin composition.
[4]: The photosensitive resin composition according to any one of [1] to [3], wherein the composition gives a cured film having a transmittance of 2% or less at a wavelength of 450 to 470 nm, a transmittance of 80% or more at a wavelength of 515 to 535 nm, and a transmittance of 80% or more at a wavelength of 620 to 640 nm, and having a film thickness of 1 to 10 µm.
[5]: A photosensitive resin film comprising a dried product of the photosensitive resin composition according to any one of [1] to [4].
[6]: A photosensitive dry film comprising: a support film; and the photosensitive resin film according to [5] on the support film.
[7]: A patterning process comprising the steps of:
   (i) applying the photosensitive resin composition according to any one of [1] to [4] onto a substrate, the substrate comprising a pattern formed of a photoresist containing quantum dots capable of emitting red or green fluorescence, to form a photosensitive resin film on the substrate;
   (ii) exposing the photosensitive resin film to light; and
   (iii) developing the exposed photosensitive resin film with a developer to dissolve and remove an unexposed portion to form a pattern having a film thickness of 1 to 10 µm on the photoresist containing quantum dots.
[8]: The patterning process according to [7], wherein post-baking is not performed after the step (ii).
[9]: A patterning process comprising the steps of:
   (i') bonding the photosensitive resin film of the photosensitive dry film according to [6] to a substrate, the substrate comprising a pattern formed of a photoresist containing quantum dots capable of emitting red or green fluorescence, to form the photosensitive resin film on the substrate;
   (ii') exposing the photosensitive resin film to light; and
   (iii') developing the exposed photosensitive resin film with a developer to dissolve and remove an unexposed portion to form a pattern having a film thickness of 1 to 10 µm on the photoresist containing quantum dots.
[10]: The patterning process according to [9], wherein post-baking is not performed after the step (ii').
[11]: A display comprising: a blue LED; on the blue LED, a pattern formed of a photoresist containing quantum dots capable of emitting red or green fluorescence; and on the pattern, a pattern formed of a cured film of the photosensitive resin composition according to any one of [1] to [4], wherein the cured film absorbs blue LED light that has not been color-converted by the quantum dots to obtain from each subpixel only light that has been converted to red or green.
[12]: A micro-LED display comprising: a blue LED; on the blue LED, a pattern formed of a photoresist containing quantum dots capable of emitting red or green fluorescence; and on the pattern, a pattern formed of a cured film of the photosensitive resin composition according to any one of [1] to [4], wherein the pattern formed of the cured film has a size of 0.01 mm² or less, and the cured film absorbs blue LED light that has not been color-converted by the quantum dots to obtain from each subpixel only light that has been converted to red or green.
[13]: A laminate comprising: a photoresist containing quantum dots capable of emitting red or green fluorescence; and a cured film of the photosensitive resin composition according to any one of [1] to [4] formed on the photoresist containing quantum dots.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition for absorbing blue LED light that has been transmitted through a cured photoresist film containing quantum dots capable of emitting red or green fluorescence, the composition comprising:
(A) an acrylic resin having a (meth)acryloyl group in a side chain;
(B) a dye having a maximum absorption wavelength at any wavelength of 490 to 430 nm;
(C) an oxime-based photo-radical generator;
(D) a surfactant; and
(E) a solvent.

2. The photosensitive resin composition according to claim 1, wherein the component (A) is an alkali-insoluble resin having a weight-average molecular weight Mw of 10,000 to 50,000, a double bond equivalent of ≤ 300 g/mol, and an acid value of ≤ 10 mg KOH/g.

3. The photosensitive resin composition according to claim 1, wherein the component (B) is contained in an amount of 0.5 to 15 mass% based on a non-volatile component of the photosensitive resin composition.

4. The photosensitive resin composition according to claim 1, wherein the composition gives a cured film having a transmittance of 2% or less at a wavelength of 450 to 470 nm, a transmittance of 80% or more at a wavelength of 515 to 535 nm, and a transmittance of 80% or more at a wavelength of 620 to 640 nm, and having a film thickness of 1 to 10 µm.

5. A photosensitive resin film comprising a dried product of the photosensitive resin composition according to any one of claims 1 to 4.

6. A photosensitive dry film comprising: a support film; and the photosensitive resin film according to claim 5 on the support film.

7. A patterning process comprising the steps of:
(i) applying the photosensitive resin composition according to any one of claims 1 to 4 onto a substrate, the substrate comprising a pattern formed of a photoresist containing quantum dots capable of emitting red or green fluorescence, to form a photosensitive resin film on the substrate;
(ii) exposing the photosensitive resin film to light; and
(iii) developing the exposed photosensitive resin film with a developer to dissolve and remove an unexposed portion to form a pattern having a film thickness of 1 to 10 µm on the photoresist containing quantum dots.

8. The patterning process according to claim 7, wherein post-baking is not performed after the step (ii).

9. A patterning process comprising the steps of:
(i') bonding the photosensitive resin film of the photosensitive dry film according to claim 6 to a substrate, the substrate comprising a pattern formed of a photoresist containing quantum dots capable of emitting red or green fluorescence, to form the photosensitive resin film on the substrate;
(ii') exposing the photosensitive resin film to light; and
(iii') developing the exposed photosensitive resin film with a developer to dissolve and remove an unexposed portion to form a pattern having a film thickness of 1 to 10 µm on the photoresist containing quantum dots.

10. The patterning process according to claim 9, wherein post-baking is not performed after the step (ii').

11. A display comprising: a blue LED; on the blue LED, a pattern formed of a photoresist containing quantum dots capable of emitting red or green fluorescence; and on the pattern, a pattern formed of a cured film of the photosensitive resin composition according to any one of claims 1 to 4, wherein the cured film absorbs blue LED light that has not been color-converted by the quantum dots to obtain from each subpixel only light that has been converted to red or green.

12. A micro-LED display comprising: a blue LED; on the blue LED, a pattern formed of a photoresist containing quantum dots capable of emitting red or green fluorescence; and on the pattern, a pattern formed of a cured film of the photosensitive resin composition according to any one of claims 1 to 4, wherein the pattern formed of the cured film has a size of 0.01 mm² or less, and the cured film absorbs blue LED light that has not been color-converted by the quantum dots to obtain from each subpixel only light that has been converted to red or green.

13. A laminate comprising: a photoresist containing quantum dots capable of emitting red or green fluorescence; and a cured film of the photosensitive resin composition according to any one of claims 1 to 4 formed on the photoresist containing quantum dots.
